# EUROPEAN PATENT SPECIFICATION

(11) **EP 4 093 053 B1**
(45) Date of publication and mention of the grant of the patent: **27.11.2024**
(21) Application number: 22172097.2
(22) Date of filing: 06.05.2022
(51) Int. Cl.: H04R 25/00, H05K 5/06, H05K 9/00

(54) **A HEARING DEVICE COMPRISING A SHIELDING COMPONENT**
HÖRGERÄT MIT EINER ABSCHIRMENDEN KOMPONENTE
DISPOSITIF AUDITIF COMPRENANT UN COMPOSANT DE PROTECTION

(30) Priority: 20.05.2021 DK PA202170254
(43) Date of publication of application: 23.11.2022
(73) Proprietor: GN Hearing 2 A/S, 2750 Ballerup (DK)
(72) Inventor: KNUDSEN, Emil Holm, 2750 Ballerup (DK)

(56) References cited:
- US-A1- 2003 031 339
- US-A1- 2006 067 070

## Description

### FIELD

The present invention relates to hearing devices. More specifically, the disclosure relates to a hearing device configured to be worn at or in an ear of a user. The hearing device comprises a substrate. The substrate comprises one or more electronic components mounted on the substrate. The hearing device comprises a shielding component.

### BACKGROUND

As electronic components on a substrate produces electromagnetic noise, it is an advantage to provide that the electronic components are electromagnetically shielded, such as by a shielding component and encapsulation. US 2003/031339 A1 and US 2006/067070 A1 are are examples of prior art. There is a need for an improved hearing device with a shielding component and encapsulated electronic components and an improved method for encapsulation of electronic components in a hearing device.

### SUMMARY

Disclosed is a hearing device configured to be worn at or in an ear of a user. The hearing device comprises a substrate. The substrate comprises one or more electronic components mounted on the substrate. The hearing device comprises a shielding component. The shielding component being arranged on the substrate to provide a space between the shielding component and the substrate. The shielding component is configured to cover at least a first electronic component of the one or more electronic components on the substrate. The space between the shielding component and the substrate is at least partly filled with a fill encapsulation material configured for encapsulating at least the first electronic component. The shielding component comprises a reservoir configured to collect/accumulate any excess fill encapsulation material from the space between the shielding component and the substrate. The shielding component comprises one or more side parts being substantially perpendicular to the substrate, and wherein the shielding component comprises a top part being substantially parallel to the substrate, and wherein the reservoir is provided as a recess in the top part of the shielding component.

When producing hearing devices there may different, e.g. contradicting, requirements, one requirement may be that the hearing device should have a small size, and another requirement may be that there should be efficient antennas in the hearing device, however such antennas might impact each other or the charger components.

Thus, it is an advantage of the present hearing device that it solves the above mentioned problems by adding a shielding over critical components. The shielding is provided in the form of a shielding component. The shielding component may provide electromagnetic shielding. The shielding component may provide electromagnetic shielding of at least the first electronic component of the one or more electronic components. The first electronic component may be a critical component. A critical component may be a component which is important for the functionality of the hearing device. A critical component may be a component which is a source of electromagnetic interference.

It is a further advantage of present hearing device that it provides reliability and protection against the environment. When electronic components are located under the shielding component, the electronic components are protected against the environment both by the shielding component itself but also by a fill encapsulation material, also called underfill material, which can be filled into the shielding component to encapsulate the electronic components. Furthermore, due to the shielding component, the application of the fill encapsulation material can be better controlled because it is filled into the shielding component and thereby the filling of the fill encapsulation material into the shielding component becomes more realiable. When the filling of the fill encapsulation material is performed by using the shielding component, then there may be an improved protection of the electronic components because the filling can be controlled and done correctly.

It is an advantage of the present hearing device that the shielding component minimizes the impact of the variation in the filling of the fill encapsulation material and ensures that the space or volume underneath the shielding component is completely filled.

It is an advantage that the reservoir in the shielding component will lower the impact of unprecise filling of fill encapsulation material and lower the impact of variances of the parts of the shielding component. By adding a reservoir to the shielding component a controlled extra volume of fill encapsulation material can be applied in the reservoir. If the shielding component has a slightly bigger volume than a standard, the shielding component will just suck more fill encapsulation material in from the reservoir. If the shielding component has a slightly smaller volume than a standard, the excess fill encapsulation material will just be collected/accumulated in the reservoir.

It is an advantage of the reservoir, that by inspecting the reservoir it easy to determine if the shielding component is completely filled with fill encapsulation material or not.

Prior art shielding components have been made flat and with some holes to fill in. The prior art shielding components have the problem that it is difficult to control the amount of underfill in the production. Tolerances of the parts and productions variance, such as filling time and amount of material, provides a big variation in the filling, and has the problems of overflow and/or missing material under the shielding component.

Such variations create a weak spot for the construction and unprotected components may easily corrode.

Thus, it is an advantage of the present hearing device that it provides better and more consistent environmental protection for the electronic components under the shielding component. Furthermore, it is an advantage of the present hearing device that it is easier to produce. Furthermore, is an advantage of the present hearing device that it can be produced to have a smaller design because the shielding component can be made as small as possible and because it can be inspected if the shielding component has been filled as desired by inspection of the reservoir.

It is an advantage to encapsulate electronic components on a substrate, such as a printed circuit board (PCB) in a hearing device. Encapsulation may provide an electromagnetic (EM) shield of the electronic components. Such EM shield is an advantage as the electronic components on a substrate may produce electromagnetic (EM) noise. In electronic devices, such as hearing devices, there may be magnetic coils or electromagnetic coils, e.g. for providing wireless communication with other electronic devices and/or for transmission or reception of radio frequency signals. In a hearing device, there may be a magnetic induction (MI) coil and/or there may be a tele coil. These coils should be electromagnetically (EM) shielded from the electronic components. The electromagnetic field of the electronic components may be an electric field or a magnetic field, when in the near field of the emitting waves. If the electromagnetic field is impending, e.g. from other devices, like mobile phones, hearing aid accessories etc., then it may be electromagnetic since it may then be in the far field. In particular, when using rechargeable batteries in an electronic device, the rechargeable battery may have a high voltage, and such high voltage may disturb for example a magnetic induction (MI) coil. High voltage may be converted to a lower voltage by e.g. a converter. The converter may emit electrical and/or magnetic noise, depending on conversion topology.

It is an advantage to encapsulate electronic components, as encapsulation may also provide mechanical protection of for example discrete components, integrated circuit (IC) chips and bonding wires.

It is an advantage to encapsulate electronic components, as encapsulation may also provide that moist around the electronic components can be avoided or reduced, thereby reducing the risk of corrosion.

It is an advantage that the encapsulation protects the electronic components from moisture, dust, dirt and solvents.

The hearing device is configured to be worn at an ear of a user. Thus, the hearing device may be worn in the ear, in the ear canal, behind the ear etc.

The hearing device comprises a substrate. The substrate may be a printed circuit board (PCB). The substrate may be a separate plate which is attached to the PCB. The substrate may be a a carrier printed circuit board (PCB), or a panel configured to be mounted on a printed circuit board. The substrate may be configured to mechanically support and electrically connect one or more electronic components using e.g. conductive tracks or pads. The substrate may comprise one or more sheet layers of a conductive layer, laminate, or film such as of copper e.g. laminated onto and/or between sheet layers of a non-conductive substrate.

The substrate comprises one or more electronic components mounted on the substrate. The electronic components may be surface mounted components such as transistors, resistors, capacitors, integrated circuits, inductors, diodes etc. The electronic components may be one or more batteries, such as rechargeable batteries. The electronic components may be components of a power management circuit or of a power supply circuit of the hearing device.

The hearing device comprises a shielding component. The shielding component may be a shielding can, e.g. a punched/stamped metal piece. The shielding component may have a two-dimensional and/or a three dimensional shape. The shielding component may have about e.g. 0.1 mm thickness of material, and be about e.g. 1 mm high, 7 mm long, and 1.3 mm wide.

The shielding component is arranged on the substrate to provide a space between the shielding component and the substrate. The shielding component may be grounded to a ground plate or gound ring of the substrate, such as fixed/soldered to the substrate.

The space between the shielding component and the substrate may be an enclosed space, or an at least partly enclosed space.

The shielding component is configured to cover at least a first electronic component of the one or more electronic components on the substrate. The shielding component may physically shield or cover the electronic component. The shielding component may be arranged above or extend above or extend over the electronic component. The shielding component may also electromagnetically shield the electronic component.

The shielding component may cover at least a first electronic component of the one or more electronic components on the substrate. The shielding component may cover all the electronic components on the substrate or only some of the electronic components or only one electronic component. The shielding component may cover at least two electronic components, such as a first and a second electronic component. There may be electronic components on the substrate which are not covered by the shielding component, e.g. if these component are not electromagnetically disturbing.

The first electronic component may be a part of or be a power supply unit such as a switch-mode power supply, e.g. comprising a switch capacitor and/or an inductor, e.g. being the first electronic component. A power supply unit, or power management circuit, may have one or more coils, e.g. an inductor, which may electromagnetically disturb one or more antennas in the hearing device, as the antennas may also comprise coils, such as the magnetic induction (Ml) coils for the ear-to-ear (E2E) communication between two hearing devices.

The first electronic component may be a part of or be an integrated circuit. Integrated circuits are often a source of electromagnetic interference (EMI).

The shielding component may be configured to reduce the EMI of the electronic components, such as of pthe ower supply unit or power management circuit, or of the integrated circuits (ICs). This may be because the shielding component may be electrically conductive and/or made of metal.

The space between the shielding component and the substrate comprises at least the first electronic component. The electronic components which the shielding component covers may be e.g. 0.8 mm high, while the shielding component itself may be 1 mm high.

The space between the shielding component and the substrate is at least partly filled with a fill encapsulation material configured for encapsulating at least the first electronic component. The space may be completely filled, almost completely filled, half filled, partly filled etc. Even if the first electronic component takes up most of the space, e.g. in the height, in the width and/or in the length, there will still be room for the fill encapsulation material, as the fill encapsulation material may flow under the first electronic component, as the electronic componments may only be attached at a few attachements points to the substrate, and into every corner of the space. The fill encapsulation material may be made of epoxy, acrylic and/or polymer. The fill encapsulation material provides protection against the environment, such as againts moist, dirt, corrosion etc. The fill encapsulation material will flow and fill all the space between the electronic components due to capillary forces.

The shielding component comprises a reservoir configured to collect/accumulate any excess fill encapsulation material from the space between the shielding component and the substrate. The reservoir is a recess in the top part of the shielding component. The reservoir may for example have the dimensions: about 4 mm long, about 0.5 mm wide and about 0.25 mm high/deep.

It is an advantage that the one or more electronic components are encapsulated and electromagnetically shielded. This may be obtained by providing that the shielding component comprises an electrically conducting material. The electrically conducting material may be a metal or a metal alloy such as for example silver (Ag). The shielding component may be placed on top of the ground ring of the substrate or may be connected to the ground ring. The shielding component is placed around the electronic components to be encapsulated. The shielding component may be an at least partly closed structure. Thereby the shielding component provides the electromagnetic shielding of the electronic components.

When the electronic components are encapsulated on the substrate, the substrate may be mounted in a hearing device, whereby the electronic components can be performing various functions in the hearing device.

According to an aspect, disclosed is a method of manufacturing a substrate for a hearing device configured to be worn at an ear of a user. The hearing device comprises the substrate. The substrate comprises one or more electronic components mounted on the substrate including a first electronic component. The hearing device comprises a shielding component comprising one or more side parts, a top part and a reservoir. The reservoir is provided on the top part of the shielding component. The method comprises providing the substrate comprising the one or more electronic components including the first electronic component. The method comprises arranging the shielding component on the substrate to provide a space between the shielding component and the substrate, such that the one or more side parts of the shielding component are substantially perpendicular to the substrate and such that the top part of the shielding component is substantially parallel to the substrate, where the shielding component covers at least the first electronic component of the one or more electronic components on the substrate. The method comprises filling the space between the shielding component and the substrate at least partly with a fill encapsulation material configured for encapsulating at least the first electronic component. The method comprises collecting/accumulating, in the reservoir of the shielding component, any excess fill encapsulation material from the space between the shielding component and the substrate.

For example, the amount of fill encapsulation material to be filled in the space may be about 34 mg. If there is not volume enough for the applied amount of fill encapsulation material in the space, then the excess fill encapsulation material will be collected in the reservoir. If there is volume enough for the applied amount of fill encapsulation material in the space, then no excess fill encapsulation material will be collected in the reservoir. Then the operator can decide to apply more fill encapsulation material in the space and visually inspect the reservoir to see when excess fill encapsulation material accumulates in the reservoir.

The method comprises arranging the shielding component on the substrate to provide a space between the shielding component and the substrate. The shielding component may be soldered to the substrate, so that no fill encapsulation material will escape between the shielding component and the substrate.

Further steps of the method may comprise curing the fill encapsulation material, visually inspecting the reservoir, adding more fill encapsulation material or another material in the space if no excess fill encapsulation material is visible in the reservoir after some time. The other material to fill in the space may be a coat, a glue, a varnish, a finish, a laquer, a sealing wax etc.

More fill encapsulation material may be applied in the space before curing and/or after curing. If any air bubbles were present in the fill encapsulation material when applied in the space, then these air bubbles may disappear before curing and/or during curing. Thus, when air bubbles are present in the space, there may be less fill encapsulation material in the space, and excess fill encapsulation material may be present in the reservoir. However, when the air bubbles disappear from the space, there may be more fill encapsulation material in the space, and the excess fill encapsulation material may flow away from the reservoir and into the space, and thereby no excess fill encapsulation materil may be present in the reservoir anymore. Theremore, more fill encapsulation material may be applied in the space before curing and/or after curing.

Finally, the method may comprise assembling the substrate, which comprises the electronic components and the shielding component and the fill encapsulation material, in the hearing device.

In some embodiments the reservoir is configured to be visually inspectable, whereby any excess fill encapsulation material in the reservoir is configured to be visible. The reservoir should be visually inspectable after filling of the fill encapsulation material and before the final assembly of the hearing device. Excess fill encapsulation material in the reservoir should be visible to a human operator and/or to a machine configured for inspection.

In some embodiments the shielding component comprises one or more side parts being substantially perpendicular to the substrate, and wherein the shielding component comprises a top part being substantially parallel to the substrate, and wherein the reservoir is provided on the top part of the shielding component.

In some embodiments the shielding component comprises an internal face, where the internal face points towards the substrate thereby defining the space between the shielding component and the substrate, and where the fill encapsulation material is provided through the shielding component to the internal face of the shielding component; and where the shielding component comprises an external face, where the external face points towards the surroundings, and where the reservoir is provided on the external face of the shielding component.

In some embodiments the shielding component is made of an electrically conductive material, and wherein the shielding component is an electromagnetically shielding component configured for electromagnetically shield at least the first electronic component.

The electrically condutive material may be made of a metal, a metal alloy or the like. The electrically conductive material may comprise silver, e.g. german silver, and/or an alloy comprising silver. The shielding component will reduce the electromagnetic interference (EMI) of the electronic components, e.g. integrated circuits (ICs), because the shielding component is electrically conductive, e.g. made of metal.

In some embodiments the shielding component is made of a solid metal plate. The solid metal plate may be punched/stamped into the desired shape. The shielding component will reduce the electromagnetic interference (EMI) of the electronic components, e.g. integrated circuits (ICs), because the shielding component is made of metal being conductive.

In some embodiments the shielding component comprises at least one filling hole configured for receiving the fill encapsulation material to fill the space between the shielding component and the substrate. The filling hole may be a through-hole in the shielding component, such as in a top part or side part of the shielding component. There may be two or more filling holes.

In some embodiments the at least one filling hole is provided in the reservoir. It is an advantage to have the filling hole in the reservoir because then any fill encapsulation material which is spilt when applying the fill encapsulation material to the space can be collected in the reservoir. It is an advantage to have the filling hole in the reservoir because then any excess fill encapsulation material can be collected in the reservoir, both before the fill encapsulation material may flow into the space and/or after the fill encapsulation material has been applied to the space and the space is full.

Furthermore, the filling hole may be provided away from the first electronic component, such as not directly above the first electronic component but displaced relative to the position of the first electronic component in the space.

In some embodiments the shielding component comprises one or more air escape holes configured for allowing air to escape the space between the shielding component and the substrate during and/or after the fill encapsulation material is filled in the space. The fill encapsulation material should flow into the space and fill out at least partly the space from the bottom and up, i.e. filling the substrate and under the electronic components and at least partly up the sides of the electronic components. The fill encapsulation material may fill the entire space or almost the entire space. There may be a small volume in the top of the space which may not be filled. When the fill encapsulation material fills the space, air from the space may escape via the air escape holes in the shielding component. The air escape holes may be for venting the space. The air escape holes may be provided in the top part and/or in the side parts of the shielding component. The air escape holes may be provided along an edge between the top part and the side part(s) of the shielding component. The air escape holes may be made so small that the capillary forces will prevent the fill encapsulation material from flowing out of the air escape holes.

In some embodiments the shielding component has a first height above the substrate, wherein the first height is configured to match/correspond to a second height being the height of at least the first electronic component on the substrate. Thus the first height of the shielding component and the second height of the first electronic component may be substantially the same, the first height of the shielding component may just be a little bit higher than the second height of the electronic component. This is an advantage as this is reducing the volume/size of the shielding component, whereby the size of the hearing device can be reduced.

In some embodiments the shielding component has a first height above the substrate which varies to match/correspond to different second heights of one or more of the electronic components on the substrate covered by the shielding component. As the electronic components covered by the shielding component may have different heights, the height of the shielding component may vary to match/correspond to the different heights of the electronic component. Thus the varying first height of the shielding component and the varying second height of the electronic components may be substantially the same, the first height of the shielding component may just be a little bit higher than the second height of the electronic component. This is an advantage as this is reducing the volume/size of the shielding component, whereby the size of the hearing device can be reduced.

In some embodiments the shielding component comprises an elevation/rise/protrusion configured for guiding the flow of fill encapsulation material in the space between the shielding component and the substrate. The elevation/rise/protrusion in the shielding component may secure that, e.g. in an end of the shielding component having a lower height, the fill encapsulation material will flow all the way out to all corners and parts of the space as fast as possible.

In some embodiments the first electronic component is at least a part of a power management circuit of the hearing device, and wherein the electromagnetic interference of the first electronic component is reduced by the shielding component.

The method comprises providing a liquid fill encapsulation material within the shielding component on the substrate. The liquid fill encapsulation material may be cured. The fill encapsulation material encapsulates the one or more electronic components. The liquid fill encapsulation material may be applied within the shielding component by a dedicated manufacturing machine. The liquid fill encapsulation material may have a specific viscosity providing that the liquid fill encapsulation material can flow and fill all surfaces, holes, cavities etc. on the substrate inside the boundaries of the shielding component. A distance between two neighbouring electronic components, e.g. a distance between the first electronic component and the second electronic component, may preferably be such that the fill encapsulation material may penetrate between the electronic components. The viscosity of the fill encapsulation material may be between 3 - 1000 Pa*s. The selected viscosity may depend on design and requirements.

The encapsulation material may contact or be substantially in contact with, e.g. adhering to, electronic component(s), e.g. the first electronic component and/or the second electronic component, for example such that a surface (or at least a part) of the fill encapsulation material adheres to the surface of the first electronic component and/or the second electronic component. It may be advantageous that the fill encapsulation material adheres to the first electronic component and/or the second electronic component, such that substantially no air is trapped between the fill encapsulation material and the surface of the first electronic component and/or the second electronic component. This may further avoid that any moisture penetrates and collects between the fill encapsulation material and the electronic component(s), such as the first electronic component and/or the second electronic component, which may lead to damage or misfunction of the electronic component(s).

The fill encapsulation material may be an epoxy based material. The fill encapsulation material may for example be a material such as Namics U8443, Chipcoat U8443, G8345, or the like, e.g. similar names but with a different suffix. The fill encapsulation material is configured to solidify. The liquid fill encapsulation material is configured to solidify or become solid after being provided or applied on the substrate. Solid or solidified in this respect may mean that at least a part of the fill encapsulation material is solid. Solidified may not mean cured. Curing may be performed in another step. Curing may comprise heat curing. The fill encapsulation material may change from first being a liquid material, then a solid material, and then a cured material.

It is an advantage to use thermal curing at it allows for curing also in dark areas that an UV light cannot reach. Thus, if the material, such as the fill encapsulation material, is in black colour and/or covered by the shielding component, the material can be cured using thermal curing.

The design of the substrate, such as a printed circuit board (PCB), may have a ground ring around the components or area that needs EM shielding. The electronic components, such as surface mounted devices (SMD), may first be assembled on the substrate before providing the shielding component. Then the following process may be performed. First apply shielding component on the substrate, such as on top of ground ring. Then the fill encapsulation material is applied inside the shielding component. Then the fill encapsulation material may be cured.

The fill encapsulation material may comprise an epoxy based material, an acrylic based material and/or a polymer based material. This material may be a non-conductive material.

Epoxy refers to any of the basic components or cured end products of epoxy resins, as well as a colloquial name for the epoxide functional group. Epoxy resins, also known as polyepoxides, are a class of reactive prepolymers and polymers which contain epoxide groups. Epoxy resins may be reacted (cross-linked) either with themselves through catalytic homopolymerisation, or with a wide range of co-reactants including polyfunctional amines, acids, acid anhydrides, phenols, alcohols and thiols, usually called mercaptans. These co-reactants are often referred to as hardeners or curatives, and the cross-linking reaction is commonly referred to as curing. Reaction of polyepoxides with themselves or with polyfunctional hardeners forms a thermosetting polymer, often with favorable mechanical properties and high thermal and chemical resistance.

The shielding component defines a space surrounding an area of the substrate. The area may comprise the electronic components to be encapsulated.

The substrate may comprise a conductive track interconnected with a ground plane of the substrate. The shielding component may be provided on at least a part of the conductive track. The conductive track may be interconnected with the ground plane through a "via" or via a "through hole" in the substrate. The shielding component may be provided on top of the ground ring. The shielding component may be placed on top of a trace connected to the ground connection of the substrate. It is an advantage that hereby electrical grounding is obtained.

The one or more electronic components may be surface mounted components (SMC), surface mounted devices (SMD) or discrete components. The one or more electronic components may be integrated circuit chips. The one or more electronic components may comprise a system-in-a-package. The one or more electronic components may be a plurality of electronic components. At least one of the one or more electronic components may be a surface mounted component or a discrete component. At least one of the one or more electronic components may be an integrated circuit chip. At least one of the one or more electronic components may be a system-in-a package. The surface mounted components or discrete components may be transistors, resistors, transducers, capacitors, integrated circuits, inductors, diodes, signal processing units, batteries etc. The integrated circuit chips may be silicon chips. The system-in-a-package may be a hybrid.

The one or more electronic components may comprise a power supply unit such as switch-mode power supply e.g. comprising a switch capacitor or an inductor, e.g. as the first electronic component. The one or more electronic components may comprise a receiver such as a speaker, a microphone, a filter, an antenna e.g. a magnetic radio, and/or an interface.

The one or more electronic components may generate electromagnetic fields of different magnitudes and at different frequencies, thereby creating electromagnetic interference between the electronic components, the electromagnetic interference being more or less disturbing for other electronic components e.g. depending on the operating frequencies of the electronic components and the magnitude of the electromagnetic fields.

The one or more electronic components may comprise a first electronic component and optionally a second electronic component on the substrate. The one or more electronic components, such as the first electronic component and/or the second electronic component may be mounted to e.g. by being soldered, embedded in the substrate, or bonded e.g. wire bonded or adhesive bonded to the substrate. The method may comprise mounting a plurality of electronic components on the substrate.

Surface mounted devices or components may be assembled using a surface-mount technology (SMT) which is a method for producing electronic circuits in which the components are mounted or placed directly onto the surface of printed circuit boards (PCBs). An electronic device so made is called a surface-mount device (SMD). In industry, it has largely replaced the through-hole technology construction method of fitting components with wire leads into holes in the circuit board. Both technologies can be used on the same board, with the through-hole technology used for components not suitable for surface mounting such as large transformers and heat-sinked power semiconductors. By employing SMT, the production process speeds up. An SMT component is usually smaller than its through-hole counterpart because it has either smaller leads or no leads at all. It may have short pins or leads of various styles, flat contacts, a matrix of solder balls (BGAs), or terminations on the body of the component.

Encapsulation of the one or more electronic components comprises encapsulation of at least some of the electronic component surfaces which are exposed to the surroundings. The surface of the electronic components (EC) may point "downwards" towards the substrate, point to the "sides" towards the inside side parts or walls of the shielding component or point "upwards" towards the inside top part or roof of the shielding component. In particular, the surfaces of the EC pointing towards the sides of the shielding component and upwards towards the top part of shielding component may be encapsulated. However, the electronic components (EC) may not "stand" or "touch" on the substrate with their entire bottom surface, the EC may "float" a few micrometers or millimeters above the substrate with the majority of the their bottom surface and just be connected to be substrate at a few smaller connection points.

The hearing device may be a headset, a hearing aid, a hearable etc. The hearing device may be an in-the-ear (ITE) hearing device, a receiver-in-ear (RIE) hearing device, a receiver-in-canal (RIC) hearing device, a microphone-and-receiver-in-ear (MaRIE) hearing device, a behind-the-ear (BTE) hearing device comprising an ITE unit, or a one-size-fits-all hearing device etc.

The hearing device is configured to be worn by a user. The hearing device may be arranged at the user's ear, on the user's ear, in the user's ear, in the user's ear canal, behind the user's ear etc. The user may wear two hearing devices, one hearing device at each ear. The two hearing devices may be connected, such as wirelessly connected.

The hearing device may be configured for audio communication, e.g. enabling the user to listen to media, such as music or radio, and/or enabling the user to perform phone calls. The hearing device may be configured for performing hearing compensation for the user. The hearing device may be configured for performing noise cancellation etc.

The hearing device may comprise a RIE unit. The RIE unit typically comprises the earpiece such as a housing, a plug connector, and an electrical wire/tube connecting the plug connector and earpiece. The earpiece may comprise an in-the-ear housing, a receiver, such as a receiver configured for being provided in an ear of a user, and an open or closed dome. The dome may support correct placement of the earpiece in the ear of the user. The RIE unit may comprise an input transducer e.g. a microphone or a receiver, an output trasducer e.g. an speaker, one or more sensors, and/or other electronics. Some electronic components may be placed in the earpiece, while other electronic components may be placed in the plug connector. The receiver may be with a different strength, i.e. low power, medium power, or high power. The electrical wire/tube provides an electrical connection between electronic components provided in the earpiece of the RIE unit and electronic components provided in the BTE unit. The electrical wire/tube as well as the RIE unit itself may have different lengths.

The hearing device may comprise an output transducer e.g. a speaker or receiver. The output transducer may be a part of a printed circuit board (PCB) of the hearing device. The output transducer may be arranged on a printed circuit board (PCB) of the hearing device. The output transducer may not be a part of the PCB of the hearing device. The output transducer may be configured to be arranged on the PCB of the hearing device. For instance, the output transducer may be configured to be arranged on an allocated position/area on the PCB of the hearing device. The output transducer may be arranged through a hole in the PCB.

The hearing device may comprise a first input transducer, e.g. a microphone, to generate one or more microphone output signals based on a received audio signal. The audio signal may be an analogue signal. The microphone output signal may be a digital signal. Thus, the first input transducer, e.g. microphone, or an analogue-to-digital converter, may convert the analogue audio signal into a digital microphone output signal. All the signals may be sound signals or signals comprising information about sound.

The hearing device may comprise a signal processor. The one or more microphone output signals may be provided to the signal processor for processing the one or more microphone output signals. The signals may be processed such as to compensate for a user's hearing loss or hearing impairment. The signal processor may provide a modified signal. All these components may be comprised in a housing of an ITE unit or a BTE unit. The hearing device may comprise a receiver or output transducer or speaker or loudspeaker. The receiver may be connected to an output of the signal processor. The receiver may output the modified signal into the user's ear. The receiver, or a digital-to-analogue converter, may convert the modified signal, which is a digital signal, from the processor to an analogue signal. The receiver may be comprised in an ITE unit or in an earpiece, e.g. RIE unit or MaRIE unit. The hearing device may comprise more than one microphone, and the ITE unit or BTE unit may comprise at least one microphone and the RIE unit may also comprise at least one microphone.

The hearing device signal processor may comprise elements such as an amplifier, a compressor and/or a noise reduction system etc. The signal processor may be implemented in a signalprocessing chip or on the PCB of the hearing device. The hearing device may further have a filter function, such as compensation filter for optimizing the output signal.

The hearing device may furthermore comprise a wireless communication unit or chip, such as a wireless communication circuit or a magnetic induction chip, for wireless data communication interconnected with an antenna, such as an radio frequency (RF) antenna or a magnetic induction antenna, for emission and reception of an electromagnetic field. The wireless communication unit including a radio or a transceiver, may connect to the hearing device signal processor and the antenna, for communicating with one or more external devices, such as one or more external electronic devices, including at least one smart phone, at least one tablet, at least one hearing accessory device, including at least one spouse microphone, remote control, audio testing device, etc., or, in some embodiments, with another hearing device, such as another hearing device located at another ear, typically in a binaural hearing device system.

The present invention relates to different aspects including the hearing device and the method described above and in the following, and corresponding electronic devices, device parts, systems, kits and methods, each yielding one or more of the benefits and advantages described in connection with the first mentioned aspect, and each having one or more embodiments corresponding to the embodiments described in connection with the first mentioned aspect and/or disclosed in the appended claims.

### BRIEF DESCRIPTION OF THE DRAWINGS

The above and other features and advantages will become readily apparent to those skilled in the art by the following detailed description of exemplary embodiments thereof with reference to the attached drawings, in which:
Fig. 1 schematically illustrates an exemplary hearing device 2 configured to be worn at an ear of a user.
Fig. 2a) and 2b) schematically illustrates an exemplary hearing device 2, the hearing device 2 having a shielding component 8 comprising at least one filling hole 24 and one or more air escape holes 26.
Fig. 3 schematically illustrates an exemplary hearing device 2, the hearing device 2 having a shielding component 8 comprising an elevation/rise/protrusion 28.
Fig. 4 schematically illustrates an example of a hearing device 2.
Fig. 5a) and 5b) schematically illustrate an example of a block-diagram of an embodiment of a hearing device 2.
Fig. 6 schematically illustrates a flow chart of a method 100 of manufacturing a substrate for a hearing device configured to be worn at an ear of a user.

### DETAILED DESCRIPTION

Various embodiments are described hereinafter with reference to the figures. Like reference numerals refer to like elements throughout. Like elements will, thus, not be described in detail with respect to the description of each figure. It should also be noted that the figures are only intended to facilitate the description of the embodiments. They are not intended as an exhaustive description of the claimed invention or as a limitation on the scope of the claimed invention. In addition, an illustrated embodiment needs not have all the aspects or advantages shown. An aspect or an advantage described in conjunction with a particular embodiment is not necessarily limited to that embodiment and can be practiced in any other embodiments even if not so illustrated, or if not so explicitly described.

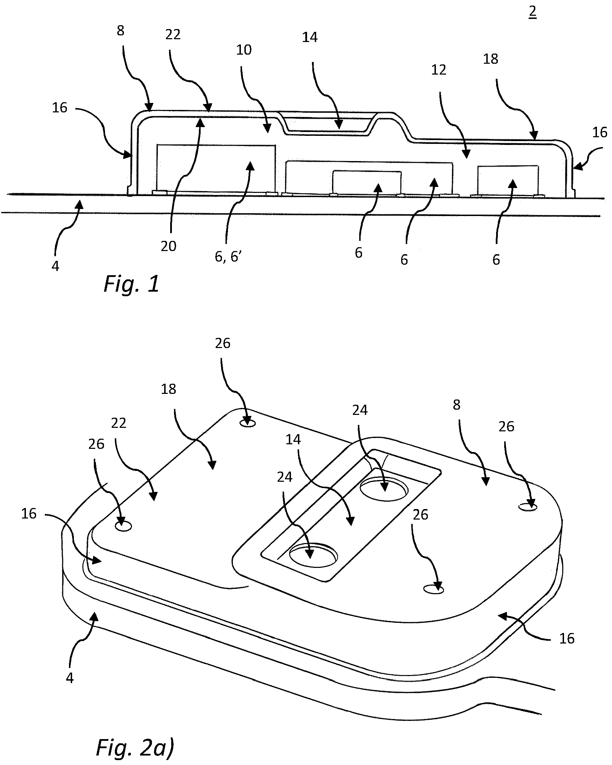

Fig. 1 schematically illustrates an exemplary hearing device 2 configured to be worn at an ear of a user. The hearing device 2 comprises a substrate 4. The substrate 4 comprises one or more electronic components 6 mounted on the substrate 4. The hearing device 2 comprises a shielding component 8. The shielding component 8 being arranged on the substrate 4 to provide a space 10 between the shielding component 8 and the substrate 4. The shielding component 8 is configured to cover at least a first electronic component 6' of the one or more electronic components 6 on the substrate 4. The space 10 between the shielding component 8 and the substrate 4 is at least partly filled with a fill encapsulation material 12 configured for encapsulating at least the first electronic component 6'. The shielding component 8 comprises a reservoir 14 configured to collect/accumulate any excess fill encapsulation material from the space 10 between the shielding component 8 and the substrate 4.

Fig. 1 further shows that the reservoir 14 is configured to be visually inspectable, whereby any excess fill encapsulation material (not shown) in the reservoir 14 is configured to be visible.

Fig. 1 shows that the shielding component 8 comprises one or more side parts 16 being substantially perpendicular to the substrate 4. Fig. 1 also shows that the shielding component 8 comprises a top part 18 being substantially parallel to the substrate 4. Fig. 1 shows that the reservoir 14 is provided on the top part 18 of the shielding component 8.

Fig. 1 shows that the shielding component 8 comprises an internal face 20, where the internal face 20 points towards the substrate 4 thereby defining the space 10 between the shielding component 8 and the substrate 4. The fill encapsulation material 12 is provided through the shielding component 8 to the internal face 20 of the shielding component 8.

Fig. 1 shows that the shielding component 8 comprises an external face 22, where the external face 22 points towards the surroundings, and where the reservoir 14 is provided on the external face 22 of the shielding component 8.

Fig. 1 furthermore shows that the shielding component 8 has a first height, i.e. vertical distance, above the substrate 4, wherein the first height is configured to match/correspond to a second height, i.e. vertical distance, being the height of at least the first electronic component 6' on the substrate 4. Thus, the first height of the shielding component 8 and the second height of the first electronic component 6' may be substantially the same, the first height of the shielding component 8 may just be a little bit higher than the second height of the first electronic component 6'.

Fig. 1 further shows that the shielding component 8 has a first height, i.e. vertical distance, above the substrate 4 which varies to match/correspond to different second heights, i.e. vertical distances, of one or more of the electronic components 6 on the substrate 4 covered by the shielding component 8. As the electronic components 6 covered by the shielding component 8 may have different heights, i.e. vertical distances, the height of the shielding component 8 may vary to match/correspond to the different heights of the electronic components 6. Thus the varying first height of the shielding component 8 and the varying second height of the electronic components 6 may be substantially the same, the first height of the shielding component 8 may just be a little bit higher than the second height of the electronic component 6.

Fig. 2a) and 2b) schematically illustrates an exemplary hearing device 2 configured to be worn at an ear of a user. The hearing device 2 comprises a substrate 4. The substrate 4 comprises one or more electronic components (not shown) mounted on the substrate 4. The hearing device 2 comprises a shielding component 8. The shielding component 8 being arranged on the substrate 4 to provide a space (not shown) between the shielding component 8 and the substrate 4. The shielding component 8 is configured to cover at least a first electronic component (not shown) of the one or more electronic components on the substrate 4. The space between the shielding component 8 and the substrate 4 is at least partly filled with a fill encapsulation material (not shown) configured for encapsulating at least the first electronic component. The shielding component 8 comprises a reservoir 14 configured to collect/accumulate any excess fill encapsulation material from the space between the shielding component 8 and the substrate 4.

Fig. 2a) shows the shielding component 8 in a side-view perspective.

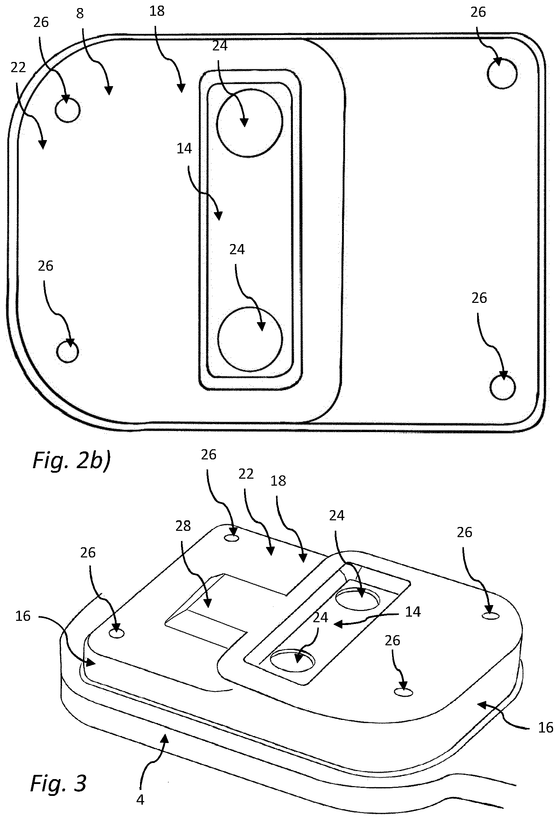

Fig. 2b) shows the shielding component 8 in a top view perspective.

Fig. 2a) and 2b) further shows that the reservoir 14 is configured to be visually inspectable, whereby any excess fill encapsulation material (not shown) in the reservoir 14 is configured to be visible.

Fig. 2a) shows that the shielding component 8 comprises one or more side parts 16 being substantially perpendicular to the substrate 4. Fig. 2a) and 2b) also shows that the shielding component 8 comprises a top part 18 being substantially parallel to the substrate 4. Fig. 2a) and 2b) shows that the reservoir 14 is provided on the top part 18 of the shielding component 8.

Fig. 2a) and 2b) shows that the shielding component 8 comprises an external face 22, where the external face 22 points towards the surroundings, and where the reservoir 14 is provided on the external face 22 of the shielding component 8. The fill encapsulation material (not shown) is provided through the shielding component 8 to an internal face (not shown) of the shielding component 8, the internal face pointing towards the substrate 4 thereby defining the space between the shielding component 8 and the substrate 4.

Fig. 2a) and 2b) shows that the shielding component 8 comprises at least one filling hole 24 configured for receiving the fill encapsulation material to fill the space between the shielding component 8 and the substrate 4. The filling hole 24 may be a through-hole in the shielding component 8. The filling hole 24 is shown in the top part 18 of the shielding component 8. In fig. 2a) and 2b) two filling holes 24 are shown.

Fig. 2a) and 2b) shows that the at least one filling hole 24 is provided in the reservoir 14.

Fig. 2a) and 2b) shows that the shielding component 8 comprises one or more air escape holes 26 configured for allowing air to escape the space between the shielding component 8 and the substrate 4 during and/or after the fill encapsulation material is filled in the space. The air escape holes 26 is shown in the top part 18 of the shielding component 8. The air escape holes 26 are provided along an edge of the top part 18 of the shielding component.

Fig. 3 schematically illustrates an exemplary hearing device 2 configured to be worn at an ear of a user. The hearing device 2 comprises a substrate 4. The substrate 4 comprises one or more electronic components (not shown) mounted on the substrate 4. The hearing device 2 comprises a shielding component 8. The shielding component 8 being arranged on the substrate 4 to provide a space (not shown) between the shielding component 8 and the substrate 4. The shielding component 8 is configured to cover at least a first electronic component (not shown) of the one or more electronic components on the substrate 4. The space between the shielding component 8 and the substrate 4 is at least partly filled with a fill encapsulation material (not shown) configured for encapsulating at least the first electronic component. The shielding component 8 comprises a reservoir 14 configured to collect/accumulate any excess fill encapsulation material from the space between the shielding component 8 and the substrate 4.

Fig. 3 shows the shielding component 8 in a side-view perspective.

Fig. 3 further shows that the reservoir 14 is configured to be visually inspectable, whereby any excess fill encapsulation material (not shown) in the reservoir 14 is configured to be visible.

Fig. 3 shows that the shielding component 8 comprises one or more side parts 16 being substantially perpendicular to the substrate 4. Fig. 3 also shows that the shielding component 8 comprises a top part 18 being substantially parallel to the substrate 4. Fig. 3 shows that the reservoir 14 is provided on the top part 18 of the shielding component 8.

Fig. 3 shows that the shielding component 8 comprises an external face 22, where the external face 22 points towards the surroundings, and where the reservoir 14 is provided on the external face 22 of the shielding component 8. The fill encapsulation material (not shown) is provided through the shielding component 8 to an internal face (not shown) of the shielding component 8, the internal face pointing towards the substrate 4 thereby defining the space between the shielding component 8 and the substrate 4.

Fig. 3 shows that the shielding component 8 comprises at least one filling hole 24 configured for receiving the fill encapsulation material to fill the space between the shielding component 8 and the substrate 4. The filling hole 24 may be a through-hole in the shielding component 8.

The filling hole 24 is shown in the top part 18 of the shielding component 8. In fig. 3 two filling holes 24 are shown.

Fig. 3 shows that the at least one filling hole 24 is provided in the reservoir 14.

Fig. 3 shows that the shielding component 8 comprises one or more air escape holes 26 configured for allowing air to escape the space between the shielding component 8 and the substrate 4 during and/or after the fill encapsulation material is filled in the space. The air escape holes 26 is shown in the top part 18 of the shielding component 8. The air escape holes 26 are provided along an edge of the top part 18 of the shielding component.

Fig. 3 shows that the shielding component 8 comprises an elevation/rise/protrusion 28 configured for guiding the flow of fill encapsulation material in the space between the shielding component 8 and the substrate 3. The elevation/rise/protrusion 28 is shown to be provided in an end of the shielding component 8 having a lower height than another end of the shielding component 8. The elevation/rise/protrusion 28 in the shielding component 8 may secure that the fill encapsulation material will flow all the way out to all corners and parts of the space between the shilding component 8 and the substrate 4 as fast as possible.

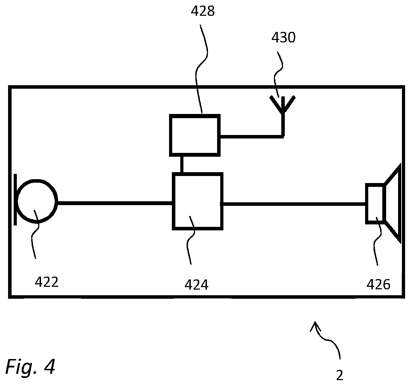

Fig. 4 schematically illustrates an example of a hearing device 2, such as a hearing aid. The hearing device 2 comprises a microphone 422, for receiving an input signal and converting it into an audio signal. The audio signal is provided to a processing unit 424 for processing the audio signal and providing a processed output signal for compensating a hearing loss of a user of the hearing device 2. A receiver 426 is connected to an output of the processing unit 424 for converting the processed output signal into an output sound signal, e.g. a signal modified to compensate for a user's hearing impairment. Typically, the receiver 426 comprises a transducer, and the receiver 426 is often referred to as a speaker. The processing unit 424 may comprise elements such as amplifiers, compressors, noise reduction systems, etc. The hearing device 420 may further comprise a wireless communication unit 428 for wireless data communication interconnected with an antenna structure 430 for emission and reception of an electromagnetic field. The wireless communication unit 428, such as a radio or a transceiver, connects to the processing unit 424 and the antenna structure 430, for communicating with an electronic device, an external device, or with another hearing device, such as another hearing aid located in/on/at another ear of the user, typically in a binaural hearing system. The hearing device 2 may comprise two or more antenna structures.

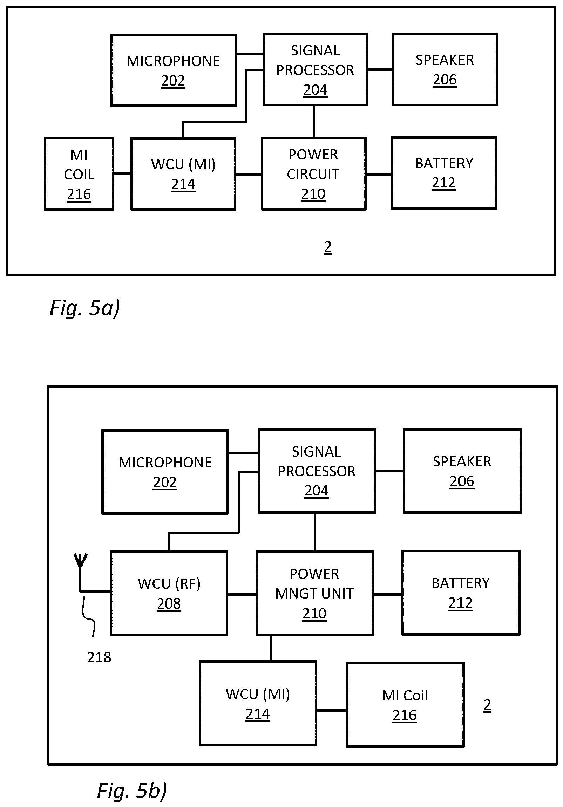

Fig. 5a) and 5b) schematically illustrate an example of a block-diagram of an embodiment of a hearing device 2. In fig. 5a), the hearing device 2 comprises a first transducer, i.e. microphone 202, to generate one or more microphone output signals based on a received an audio signal. The one or more microphone output signals are provided to a signal processor 204 for processing the one or more microphone output signals. A receiver or speaker 206 is connected to an output of the signal processor 204 for converting the output of the signal processor into a signal modified to compensate for a user's hearing impairment, and provides the modified signal to the speaker 206.

The hearing device signal processor 204 may comprise elements such as an amplifier, a compressor and/or a noise reduction system etc. The signal processor 204 may be implemented in a signal processing chip 204'. The hearing device may further have a filter function, such as compensation filter for optimizing the output signal.

The hearing device 2 further comprises a wireless communication unit 214 interconnected with magnetic induction antenna 216 such as a magnetic induction coil. The wireless communication unit 214 and the magnetic induction antenna 216 may be configured for wireless data communication using emission and reception of magnetic field. The wireless communication unit may be implemented as a wireless communication chip 214', such as a magnetic induction control chip 214'.

The hearing device 200 further comprises a power source 212, such as a battery or a rechargeable battery. Furthermore, a power management unit 210 is provided for controlling the power provided from the battery 212 to the signal processor 204, the receiver, the one or more microphones, the wireless communication unit (RF) 208, and the wireless communication unit (MI) 214. The magnetic induction antenna is configured for communication with another electronic device, in some embodiments configured for communication with another hearing device, such as another hearing device located at another ear, typically in a binaural hearing device system.

The hearing device 2 may furthermore have a wireless communication unit 208, such as a wireless communication circuit, for wireless data communication interconnected with an RF antenna 218 for emission and reception of an electromagnetic field. The wireless communication unit may be implemented as a wireless communication chip 208'. The wireless communication unit 208, including a radio or a transceiver, connect to the hearing device signal processor 204 and the RF antenna 218, for communicating with one or more external devices, such as one or more external electronic devices, including at least one smart phone, at least one tablet, at least one hearing accessory device, including at least one spouse microphone, remote control, audio testing device, etc., or, in some embodiments, with another hearing device, such as another hearing device located at another ear, typically in a binaural hearing device system.

The signal processor 204, the wireless communication unit (RF) 208, the wireless communication unit (MI) 214 and the power management unit 210 may be implemented as signal processing chip 204', wireless communication chip (RF) 208', wireless communication chip (MI) 214' and power management chip 210', respectively.

In Fig. 5b), a hearing device corresponding to the hearing device as shown in Fig. 5a is seen, except that in Fig. 5b, only one wireless communication unit 214 is present being interconnected with the magnetic induction antenna 216, the signal processor 204 and the power management unit 210.

Likewise, even though not shown, also a hearing device having only one wireless communication unit 208 being interconnected with an RF antenna for reception and emission of an electromagnetic field is envisaged.

The first electronic component, see fig. 1, may be at least a part of a power management circuit of the power management unit 210 of the hearing device 2, and the electromagnetic interference of the first electronic component, see fig. 1, may be reduced by the shielding component, see figs 1-3.

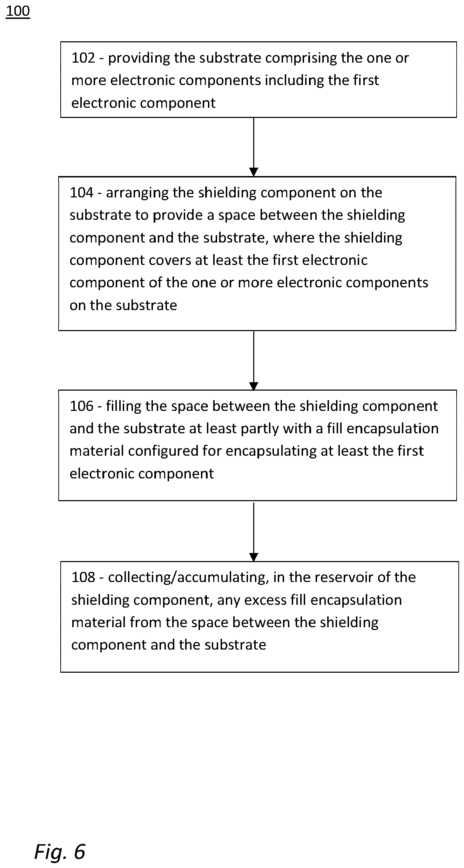

Fig. 6 schematically illustrates a flow chart of a method 100 of manufacturing a substrate for a hearing device configured to be worn at an ear of a user. The hearing device comprises the substrate. The substrate comprises one or more electronic components mounted on the substrate including a first electronic component. The hearing device comprises a shielding component comprising a reservoir.

The method comprises a step 102 of providing the substrate comprising the one or more electronic components including the first electronic component.

The method comprises a step 104 of arranging the shielding component on the substrate to provide a space between the shielding component and the substrate, where the shielding component covers at least the first electronic component of the one or more electronic components on the substrate. The shielding component may be soldered to the substrate, so that no fill encapsulation material will escape between the shielding component and the substrate.

The method comprises a step 106 of filling the space between the shielding component and the substrate at least partly with a fill encapsulation material configured for encapsulating at least the first electronic component.

The method comprises a step 108 of collecting/accumulating, in the reservoir of the shielding component, any excess fill encapsulation material from the space between the shielding component and the substrate.

### LIST OF REFERENCES

2 hearing device
4 substrate
6 one or more electronic components
6' first electronic component
8 shielding component
10 space between the shielding component and the substrate
12 fill encapsulation material
14 reservoir
16 side parts of the shielding component
18 top part of the shielding component
20 internal face of the shielding component
22 external face of the shielding component
24 filling hole
26 air escape hole
28 elevation/rise/protrusion of the shielding component
202 microphone
204 signal processor
204' a signal processing chip
206 receiver / speaker
208 the wireless communication unit (RF)
208' wireless communication chip
210 power management unit
210' power management chip
212 power source / battery
214 wireless communication unit (MI)
214' wireless communication chip
216 magnetic induction antenna
218 RF antenna
422 microphone
424 processing unit
426 receiver
428 wireless communication unit
430 antenna structure

## Claims

1. A hearing device (2) configured to be worn at or in an ear of a user, the hearing device comprising:
- a substrate (4) comprising one or more electronic components (6, 6') mounted on the substrate;
- a shielding component (8) arranged on the substrate (4) to provide a space (10) between the shielding component (8) and the substrate (4);
where the shielding component (8) is configured to cover at least a first electronic component (6') of the one or more electronic components (6, 6') on the substrate (4),
wherein the space (10) between the shielding component (8) and the substrate (4) is at least partly filled with a fill encapsulation material (12) configured for encapsulating at least the first electronic component (6');
wherein the shielding component (8) comprises a reservoir (14) configured to collect/accumulate any excess fill encapsulation material (12) from the space (10) between the shielding component (8) and the substrate (4) and
wherein the shielding component (8) comprises one or more side parts (16) being substantially perpendicular to the substrate (4), and wherein the shielding component (8) comprises a top part (18) being substantially parallel to the substrate (4), **characterized in that** the reservoir is (14) provided as a recess in the top part (18) of the shielding component (8).

2. The hearing device (2) according to any of the preceding claims, wherein the reservoir (14) is configured to be visually inspectable, whereby any excess fill encapsulation material (12) in the reservoir (14) is configured to be visible.

3. The hearing (2) device according to any of the preceding claims, wherein the shielding component (8) comprises an internal face (20), where the internal face (20) points towards the substrate (4) thereby defining the space (10) between the shielding component (8) and the substrate (4), and where the fill encapsulation material (12) is provided through the shielding component (8) to the internal face (20) of the shielding component (8); and where the shielding component (8) comprises an external face (22), where the external face (22) points towards the surroundings, and where the reservoir (14) is provided on the external face (22) of the shielding component (8).

4. The hearing device (2) according to any of the preceding claims, wherein the shielding component (8) is made of an electrically conductive material, and wherein the shielding component (8) is an electromagnetically shielding component configured for electromagnetically shield at least the first electronic component (6').

5. The hearing device (2) according to any of the preceding claims, wherein the shielding component (8) is made of a solid metal plate.

6. The hearing device (2) according to any of the preceding claims, wherein the shielding component (2) comprises at least one filling hole (24) configured for receiving the fill encapsulation material (12) to fill the space (10) between the shielding component (8) and the substrate (4).

7. The hearing device (2) according to the preceding claim, wherein the at least one filling hole (24) is provided in the reservoir (14).

8. The hearing device (2) according to any of the preceding claims, wherein the shielding component (8) has a first height above the substrate (4) which varies to match/correspond to different second heights of one or more of the electronic components (6, 6') on the substrate (4) covered by the shielding component (8).

9. The hearing device (2) according to any of the preceding claims, wherein the first electronic component (6') is at least a part of a power management circuit of the hearing device, and wherein the electromagnetic interference of the first electronic component (6') is reduced by the shielding component (8).

10. A method (100) of manufacturing a substrate for a hearing device (2) configured to be worn at or in an ear of a user, the hearing device (2) comprising:
- the substrate (4) comprising one or more electronic components (6, 6') mounted on the substrate (4) including a first electronic component (6'),
- a shielding component (8) comprising one or more side parts (16), a top part (18) and a reservoir (14), wherein the reservoir (14) is provided as a recess in the top part (18) of the shielding component (8);
the method comprises:
- providing the substrate (4) comprising the one or more electronic components (6, 6') including the first electronic component (6');
- arranging the shielding component (8) on the substrate (4) to provide a space (10) between the shielding component (8) and the substrate (4), such that the one or more side parts (16) of the shielding component (8) are substantially perpendicular to the substrate (4) and such that the top part (18) of the shielding component (8) is substantially parallel to the substrate (4), where the shielding component (8) covers at least the first electronic component (6') of the one or more electronic components (6, 6') on the substrate (4);
- filling the space (10) between the shielding component (8) and the substrate (4) at least partly with a fill encapsulation material (12) configured for encapsulating at least the first electronic component (6');
- collecting/accumulating, in the reservoir (14) of the shielding component (8), any excess fill encapsulation material (12) from the space (10) between the shielding component (8) and the substrate (4).

## Patentansprüche

1. Ein Hörgerät (2), das so konfiguriert ist, dass es an oder in einem Ohr eines Benutzers getragen wird, wobei das Hörgerät Folgendes umfasst:
- ein Substrat (4), das eine oder mehrere elektronische Komponenten (6, 6') umfasst, die auf dem Substrat montiert sind;
- eine Abschirmkomponente (8), die auf dem Substrat (4) angeordnet ist, um einen Raum (10) zwischen der Abschirmkomponente (8) und dem Substrat (4) bereitzustellen;
wobei die Abschirmkomponente (8) so konfiguriert ist, dass sie mindestens eine erste elektronische Komponente (6') der einen oder mehreren elektronischen Komponenten (6, 6') auf dem Substrat (4) abdeckt,
wobei der Raum (10) zwischen der Abschirmkomponente (8) und dem Substrat (4) zumindest teilweise mit einem Füllverkapselungsmaterial (12) gefüllt ist, das so konfiguriert ist, dass es mindestens die erste elektronische Komponente (6') verkapselt;
wobei die Abschirmkomponente (8) ein Reservoir (14) umfasst, das so konfiguriert ist, dass es überschüssiges Füllverkapselungsmaterial (12) aus dem Raum (10) zwischen der Abschirmkomponente (8) und dem Substrat (4) sammelt/ansammelt, und wobei die Abschirmkomponente (8) ein oder mehrere Seitenteile (16) umfasst, die im Wesentlichen senkrecht zum Substrat (4) verlaufen, und wobei die Abschirmkomponente (8) ein Oberteil (18) umfasst, das im Wesentlichen parallel zum Substrat (4) verläuft, **dadurch gekennzeichnet, dass** und wobei das Reservoir (14) als Aussparung im Oberteil (18) der Abschirmkomponente (8) vorgesehen ist.

2. Hörgerät (2) nach einem der vorhergehenden Ansprüche, wobei das Reservoir (14) so konfiguriert ist, dass es visuell inspizierbar ist, wobei überschüssiges Füllverkapselungsmaterial (12) im Reservoir (14) so konfiguriert ist, dass es sichtbar ist.

3. Hörgerät (2) nach einem der vorhergehenden Ansprüche, wobei die Abschirmkomponente (8) eine Innenseite (20) aufweist, wobei die Innenseite (20) zum Substrat (4) zeigt und dadurch den Raum (10) zwischen der Abschirmkomponente (8) und dem Substrat (4) definiert, und wobei das Füllverkapselungsmaterial (12) durch die Abschirmkomponente (8) zur Innenseite (20) der Abschirmkomponente (8) geführt ist; und wobei die Abschirmkomponente (8) eine Außenseite (22) aufweist, wobei die Außenseite (22) zur Umgebung zeigt, und wobei das Reservoir (14) auf der Außenseite (22) der Abschirmkomponente (8) vorgesehen ist.

4. Hörgerät (2) nach einem der vorhergehenden Ansprüche, wobei die Abschirmkomponente (8) aus einem elektrisch leitfähigen Material hergestellt ist, und wobei die Abschirmkomponente (8) eine elektromagnetisch abschirmende Komponente ist, die zum elektromagnetischen Abschirmen von zumindest der ersten elektronischen Komponente (6') konfiguriert ist.

5. Hörgerät (2) nach einem der vorhergehenden Ansprüche, wobei die Abschirmkomponente (8) aus einer massiven Metallplatte besteht.

6. Hörgerät (2) nach einem der vorhergehenden Ansprüche, wobei die Abschirmkomponente (2) mindestens ein Füllloch (24) aufweist, das zur Aufnahme des Füllverkapselungsmaterials (12) zum Füllen des Raums (10) zwischen der Abschirmkomponente (8) und dem Substrat (4) konfiguriert ist.

7. Hörgerät (2) nach dem vorhergehenden Anspruch, wobei das mindestens eine Füllloch (24) im Reservoir (14) vorgesehen ist.

8. Hörgerät (2) nach einem der vorhergehenden Ansprüche, wobei die Abschirmkomponente (8) eine erste Höhe über dem Substrat (4) aufweist, die variiert, um mit unterschiedlichen zweiten Höhen einer oder mehrerer der elektronischen Komponenten (6, 6') auf dem Substrat (4), die von der Abschirmkomponente (8) abgedeckt sind, übereinzustimmen/zu korrespondieren.

9. Hörgerät (2) nach einem der vorhergehenden Ansprüche, wobei die erste elektronische Komponente (6') zumindest Teil einer Energiemanagementschaltung des Hörgeräts ist und wobei die elektromagnetische Interferenz der ersten elektronischen Komponente (6') durch die Abschirmkomponente (8) reduziert wird.

10. Verfahren (100) zur Herstellung eines Substrats für ein Hörgerät (2), das so konfiguriert ist, dass es an oder in einem Ohr eines Benutzers getragen wird, wobei das Hörgerät (2) Folgendes umfasst:
- das Substrat (4) umfasst eine oder mehrere elektronische Komponenten (6, 6'), die auf dem Substrat (4) montiert sind, einschließlich einer ersten elektronischen Komponente (6'),
- eine Abschirmkomponente (8) umfasst ein oder mehrere Seitenteile (16), ein Oberteil (18) und ein Reservoir (14), wobei das Reservoir (14) als Vertiefung im Oberteil (18) der Abschirmkomponente (8) vorgesehen ist;
das Verfahren umfasst:
- Bereitstellen des Substrats (4), das die eine oder mehrere elektronischen Komponenten (6, 6') einschließlich der ersten elektronischen Komponente (6') umfasst;
- Anordnen der Abschirmkomponente (8) auf dem Substrat (4), um einen Raum (10) zwischen der Abschirmkomponente (8) und dem Substrat (4) bereitzustellen, so dass die eine oder mehrere Seitenteile (16) der Abschirmkomponente (8) im Wesentlichen senkrecht zum Substrat (4) stehen und so dass der obere Teil (18) der Abschirmkomponente (8) im Wesentlichen parallel zum Substrat (4) steht, wobei die Abschirmkomponente (8) mindestens die erste elektronische Komponente (6') der einen oder mehreren elektronischen Komponenten (6, 6') auf dem Substrat abdeckt.

## Revendications

1. Dispositif auditif (2) configuré pour être porté sur ou dans une oreille d'un utilisateur, le dispositif auditif comprenant :
- un substrat (4) comprenant un ou plusieurs composants électroniques (6, 6') montés sur le substrat ;
- un composant de blindage (8) disposé sur le substrat (4) pour fournir un espace (10) entre le composant de blindage (8) et le substrat (4) ;
le composant de blindage (8) étant configuré pour recouvrir au moins un premier composant électronique (6') parmi les un ou plusieurs composants électroniques (6, 6') sur le substrat (4),
l'espace (10) entre le composant de blindage (8) et le substrat (4) étant au moins partiellement rempli d'un matériau d'encapsulation de remplissage (12) configuré pour encapsuler au moins le premier composant électronique (6') ;
dans lequel le composant de blindage (8) comprend un réservoir (14) configuré pour collecter/accumuler tout excès de matériau d'encapsulation de remplissage (12) de l'espace (10) entre le composant de blindage (8) et le substrat (4) et
dans lequel le composant de blindage (8) comprend une ou plusieurs parties latérales (16) sensiblement perpendiculaires au substrat (4), et dans lequel le composant de blindage (8) comprend une partie supérieure (18) sensiblement parallèle au substrat (4), **caractérisé en ce que** et dans lequel le réservoir (14) est prévu sous la forme d'un évidement dans la partie supérieure (18) du composant de blindage (8).

2. Dispositif auditif (2) selon l'une quelconque des revendications précédentes, dans lequel le réservoir (14) est configuré pour être inspectable visuellement, de sorte que tout excès de matériau d'encapsulation de remplissage (12) dans le réservoir (14) est configuré pour être visible.

3. Dispositif auditif (2) selon l'une quelconque des revendications précédentes, dans lequel le composant de blindage (8) comprend une face interne (20), la face interne (20) étant orientée vers le substrat (4), définissant ainsi l'espace (10) entre le composant de blindage (8) et le substrat (4), et dans lequel le matériau d'encapsulation de remplissage (12) est fourni à travers le composant de blindage (8) jusqu'à la face interne (20) du composant de blindage (8) ; et dans lequel le composant de blindage (8) comprend une face externe (22), la face externe (22) étant orientée vers l'environnement, et dans lequel le réservoir (14) est prévu sur la face externe (22) du composant de blindage (8).

4. Dispositif auditif (2) selon l'une quelconque des revendications précédentes, dans lequel le composant de blindage (8) est constitué d'un matériau électroconducteur, et dans lequel le composant de blindage (8) est un composant de blindage électromagnétique configuré pour protéger électromagnétiquement au moins le premier composant électronique (6').

5. Dispositif auditif (2) selon l'une quelconque des revendications précédentes, dans lequel le composant de blindage (8) est constitué d'une plaque métallique solide.

6. Dispositif auditif (2) selon l'une quelconque des revendications précédentes, dans lequel le composant de blindage (2) comprend au moins un trou de remplissage (24) configuré pour recevoir le matériau d'encapsulation de remplissage (12) pour remplir l'espace (10) entre le composant de blindage (8) et le substrat (4).

7. Dispositif auditif (2) selon la revendication précédente, dans lequel le ou les trous de remplissage (24) sont prévus dans le réservoir (14).

8. Dispositif auditif (2) selon l'une quelconque des revendications précédentes, dans lequel le composant de blindage (8) a une première hauteur au-dessus du substrat (4) qui varie pour correspondre à différentes secondes hauteurs d'un ou plusieurs des composants électroniques (6, 6') sur le substrat (4) recouvert par le composant de blindage (8).

9. Dispositif auditif (2) selon l'une quelconque des revendications précédentes, dans lequel le premier composant électronique (6') fait au moins partie d'un circuit de gestion d'alimentation du dispositif auditif, et dans lequel l'interférence électromagnétique du premier composant électronique (6') est réduite par le composant de blindage (8).

10. Procédé (100) de fabrication d'un substrat pour un dispositif auditif (2) configuré pour être porté sur ou dans une oreille d'un utilisateur, le dispositif auditif (2) comprenant :
- le substrat (4) comprenant un ou plusieurs composants électroniques (6, 6') montés sur le substrat (4) comprenant un premier composant électronique (6'),
- un composant de blindage (8) comprenant une ou plusieurs parties latérales (16), une partie supérieure (18) et un réservoir (14), le réservoir (14) étant prévu sous la forme d'un évidement dans la partie supérieure (18) du composant de blindage (8) ;
le procédé comprend :
- la fourniture du substrat (4) comprenant le ou les composants électroniques (6, 6') comprenant le premier composant électronique (6') ;
- la disposition du composant de blindage (8) sur le substrat (4) pour ménager un espace (10) entre le composant de blindage (8) et le substrat (4), de telle sorte que la ou les parties latérales (16) du composant de blindage (8) soient sensiblement perpendiculaires au substrat (4) et de telle sorte que la partie supérieure (18) du composant de blindage (8) soit sensiblement parallèle au substrat (4), le composant de blindage (8) recouvrant au moins le premier composant électronique (6') du ou des composants électroniques (6, 6') sur le substrat
